(19) Europäisches Patentamt
European Patent Office
Office européen des brevets

(11) **EP 4 357 730 A1**

(12) **EUROPEAN PATENT APPLICATION**
published in accordance with Art. 153(4) EPC

(43) Date of publication:
**24.04.2024 Bulletin 2024/17**

(51) International Patent Classification (IPC):
*G01B 21/04* (2006.01)

(21) Application number: **22824010.7**

(52) Cooperative Patent Classification (CPC):
**G01B 21/04; H01L 22/00**

(22) Date of filing: **20.05.2022**

(86) International application number:
**PCT/CN2022/094167**

(87) International publication number:
**WO 2022/262528 (22.12.2022 Gazette 2022/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.06.2021 CN 202110666730**

(71) Applicant: **ACM Research (Shanghai), Inc.
Shanghai 201203 (CN)**

(72) Inventors:
• WANG, Hui
  Shanghai 201203 (CN)
• LIU, Wenbo
  Shanghai 201203 (CN)
• HAN, Han
  Shanghai 201203 (CN)
• JIA, Shena
  Shanghai 201203 (CN)
• TAO, Xiaofeng
  Shanghai 201203 (CN)

(74) Representative: **Osha BWB
2, rue de la Paix
75002 Paris (FR)**

(54) **DEVIATION MEASUREMENT DEVICE**

(57) A deviation measurement device, which is used for measuring the deviation between the center (O) of a substrate (W) and a standard center (O'), and comprises a reference arm (101), a moving arm (103) and a first linear module (102), wherein the moving arm (103) is provided with a first positioning claw (104), and the first positioning claw (104) is used for abutting against two points on an edge of the substrate (W); the reference arm (101) is provided with a second positioning claw (105), and the second positioning claw (105) is used for abutting against two points on the edge of the substrate (W); and the moving arm (103) is arranged opposite the reference arm (101). A connecting line between the center (x1) of the first positioning claw (104) and the center (x2) of the second positioning claw (105) is a straight line L, and the straight line L passes through the standard center (O'); the moving arm (103) can translate along the straight line L under the driving of the first linear module (102); and the first positioning claw (104) pushes the substrate (W) until the first positioning claw (104) and the second positioning claw (105) are simultaneously brought into contact with the edge of the substrate, and at this time, the center (O) of the substrate is located on the straight line L. The deviation between the center (O) of the substrate and the standard center (O') can be calculated according to the coordinates of the reference arm (101) and the coordinates of the moving arm (103). The substrate (W) may be an oval substrate or a circular substrate having a notch or a flat edge.

FIG.1

EP 4 357 730 A1

**Description**

BACKGROUND OF THE INVENTION

1. Field of the Invention

The present invention generally relates to the field of semiconductor manufacturing and, more particularly, to a device for measuring the deviation between the center of a substrate and a standard center.

2. The Related Art

In most processes of the substrate processing process, the substrate is rotated about an axis passing through the center of the substrate as the rotation axis, and the center of the substrate needs to be aligned with the center of the substrate chuck, that is, the standard center. In the substrate manufacturing process, due to the limitation of the process level, there may be deviations between the shape and size of the substrate and the shape and size of the standard substrate. Therefore, when the substrate is placed, the center of the substrate may deviate from the standard center, which will cause some problems. For example, in the substrate edge cleaning device, the substrate is clamped by the substrate chuck, and driven by the rotary drive mechanism, rotates around the rotation axis, and the cleaning nozzle is located near the edge of the substrate to clean the edge of the substrate. If there is a deviation between the center of the substrate and the standard center, the distance between the cleaning nozzle and the periphery of the substrate is not a preset value, resulting in an unsatisfactory cleaning result.

SUMMARY

An object of the present invention is to propose a device for measuring the deviation between the center of a substrate and a standard center.

In order to achieve the above objective, an embodiment of the present invention provides a deviation measurement device for measuring the deviation between the center of the substrate and the standard center, comprising a reference arm, a moving arm and a first linear module. A first positioning claw is disposed on the moving arm, and the first positioning claw is configured to abut against two points on the edge of the substrate. A second positioning claw is disposed on the reference arm, and the second positioning claw is configured to abut against two points on the edge of the substrate. The moving arm is disposed opposite to the reference arm. A connecting line between a center of the first positioning claw and a center of the second positioning claw is a straight line L, and the straight line L passes through a standard center. The first linear module is connected to the moving arm, and the moving arm can be translated along the straight line L under the driving of the first linear module, and the first positioning claw pushes the substrate until the first positioning claw and the second positioning claw are in contact with the edge of the substrate at the same time, the substrate center is located on the straight line L. The deviation between the substrate center and the standard center can be calculated according to coordinates of the reference arm and the moving arm, and the substrate may be an oval substrate or a circular substrate.

Another embodiment of the present invention provides a deviation measurement device for measuring a deviation between a substrate center and a standard center, comprising a reference arm, a moving arm and a first linear module. The reference arm is provided with a positioning claw for abutting against two points on the edge of the substrate. A contact head and a pressure sensor are disposed on the moving arm. The contact head is configured to abut against a point on the edge of the substrate. The pressure sensor is connected to the contact head, and the pressure sensor measures a pressure between the edge of the substrate and the contact head. The moving arm is opposite to the reference arm. A connecting line between the center of the positioning claw and the center of the contact head is a straight line L, and the straight line L passes through a standard center. The first linear module is connected to the moving arm, and the moving arm can be translated along the straight line L under the driving of the first linear module, and during measurement, the moving arm starts from an initial coordinate and pushes the substrate until the positioning claw and the contact head are in contact with the edge of the substrate at the same time. At this time, the center of the substrate is located on the straight line L, and the moving arm is located at an end coordinate, then, the diameter d1 of the substrate is calculated to obtain the deviation n between the center of the substrate and the standard center. The calculation formula is as follows:

$$d1 = \frac{d0 + 2\sin\theta * \left[\left(\frac{d0}{2}\right) - m\right]}{1 + \sin\theta}$$

$$n = \frac{d0 - d1}{2\sin\theta}$$

where d0 is a standard diameter, the positioning claw is V-shaped, $\theta$ is half of the opening angle of the positioning claw, m=$\Delta$1-$\Delta$0, and $\Delta$1 is a translation distance between the initial coordinate and the end coordinate of the moving arm, $\Delta$0 is a standard translation distance of the moving arm, and the standard translation distance is obtained in advance, and a method for obtaining the standard translation distance is as follows: A substrate having a standard diameter d0 is used as a substrate during measurement, and an obtained translation distance between an initial coordinate and an end coordinate of the moving arm is the standard translation distance.

## BRIEF DESCRIPTION OF THE DRAWINGS

Fig. 1 illustrates a perspective view of a deviation measurement device according to a first embodiment of the present invention.

Fig. 2 illustrates comparative diagrams of respectively measuring the substrate W' with standard size and the substrate W with non-standard size by using the deviation measurement device of the first embodiment.

Fig. 3 illustrates a state diagram of using the deviation measurement device of the first embodiment to measure a substrate with a notch.

Fig. 4 illustrates a state diagram of using the deviation measurement device of the first embodiment to measure a substrate with a flat edge.

Figs. 5a to 5c illustrate the first state change diagrams of measuring an oval substrate by using the deviation measurement device of the first embodiment.

Figs. 6a to 6b illustrate the second state change diagrams of measuring an oval substrate by using the deviation measurement device of the first embodiment.

Fig. 7 illustrates an enlarged view of a part of the structure in Fig. 1.

Fig. 8 illustrates an enlarged view of a part of the structure in Fig.3.

Fig. 9 illustrates a perspective view of the deviation measurement device installed with displacement sensors of the first embodiment.

Fig. 10 illustrates a perspective view of a deviation measurement device according to a second embodiment of the present invention.

Fig. 11 illustrates an enlarged view of a part of the structure in Fig. 10.

Fig. 12 illustrates a top view of the deviation measurement device of the second embodiment.

Fig. 13 illustrates a schematic diagram of measuring the substrate diameter d1 and the deviation n between the substrate center and the standard center of the second embodiment.

## DETAILED DESCRIPTION OF EMBODIMENTS

The principles, technical features, technical effects and technical solutions in the embodiments of the present invention will be clearly and completely described below in conjunction with the accompanying drawings.

First Embodiment

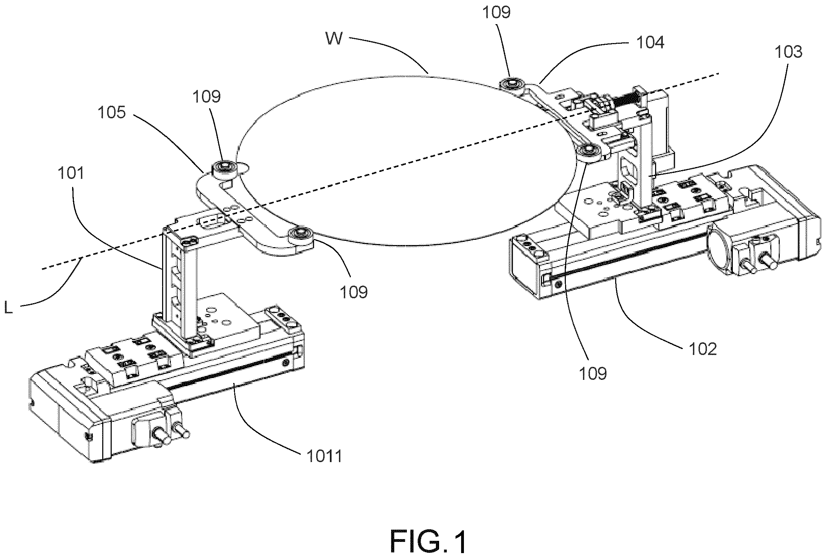

As shown in Figure 1, the embodiment of the present invention discloses a deviation measurement device, which measures the deviation between the center of the substrate and the standard center. The deviation measurement device includes a reference arm 101, a first linear module 102 and a moving arm 103. The moving arm 103 is provided with a first positioning claw 104, which is used to abut against two points on the edge of the substrate W. The reference arm 101 is provided with a second positioning claw 105, which is used to abut against two points on the edge of the substrate W. The reference arm 101 is arranged opposite to the moving arm 103, and the connecting line between the center of the first positioning claw 104 and the center of the second positioning claw 105 is a straight line L, and the straight line L passes through the standard center, and the first linear module 102 is connected with the moving arm 103, and the moving arm 103 can translate along the straight line L driven by the first linear module 102. The first positioning claw 104 pushes the substrate W until the first positioning claw 104 and the second positioning claw 105 contact with the edge of the substrate W at the same time. At this time, the center of the substrate W is located on the straight line L. The deviation between the center point of the substrate W and the standard center point can be calculated according to the coordinates of the reference arm 101 and the moving arm 103.

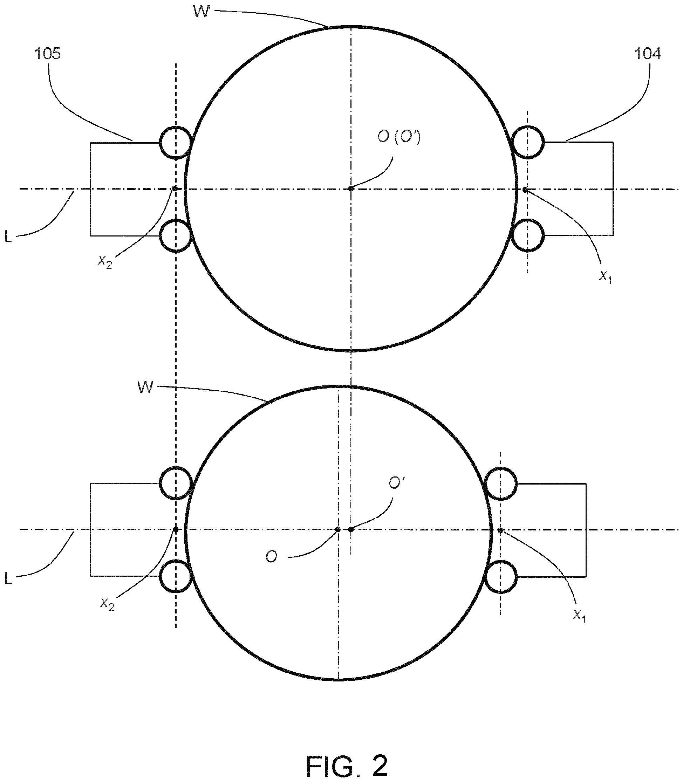

As shown in Figure 2, $x_1$ is the center point of the first positioning claw 104, and $x_2$ is the center point of the second positioning claw 105. If the substrate W' is a substrate with standard size, when the first positioning claw 104 and the second positioning claw 105 are in contact with the edge of the substrate W' at the same time, the center point O of the substrate W' is the midpoint of $x_1$ and $x_2$, the center point O of the substrate W' is also the standard center point O'; and if the substrate W is a circular substrate with non-standard size, when the first positioning claw 104 and the second positioning claw 105 are in contact with the edge of the substrate W at the same time, the center point O of the substrate W is the midpoint of $x_1$ and $x_2$. The center point O of the substrate W deviates from the standard center point O'. Since the first positioning claw 104 is relatively stationary to the moving arm 103, and the second positioning claw 105 is relatively stationary to the reference arm 101, the coordinate of the moving arm 103 can be regarded as the coordinate of the center point $x_1$ of the first positioning claw 104, and the coordinate of the reference arm 101 can be regarded as the coordinate of the center point $x_2$ of the second positioning claw 105. The deviation between the center point O of the substrate W and the standard center point O' can be calculated according to the coordinate of the moving arm 103 and the coordinate of the reference arm 101.

For example, when measuring a standard-sized substrate, if the coordinate of $x_2$ is 0, if the coordinate of $x_i$ is 310, and the coordinate of the standard center point O' is 155. When measuring a circular substrate with a non-standard size, if the coordinate of $x_2$ is 0, the coordinate of $x_1$ is 309.8, then the coordinate of the center point O of the substrate is 154.9, and the deviation between the center point O of the substrate and the standard center point O' is 0.1.

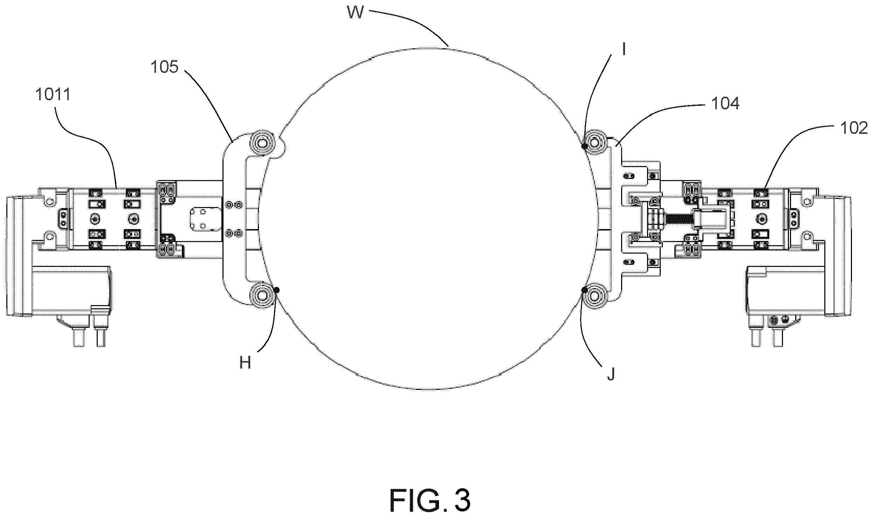

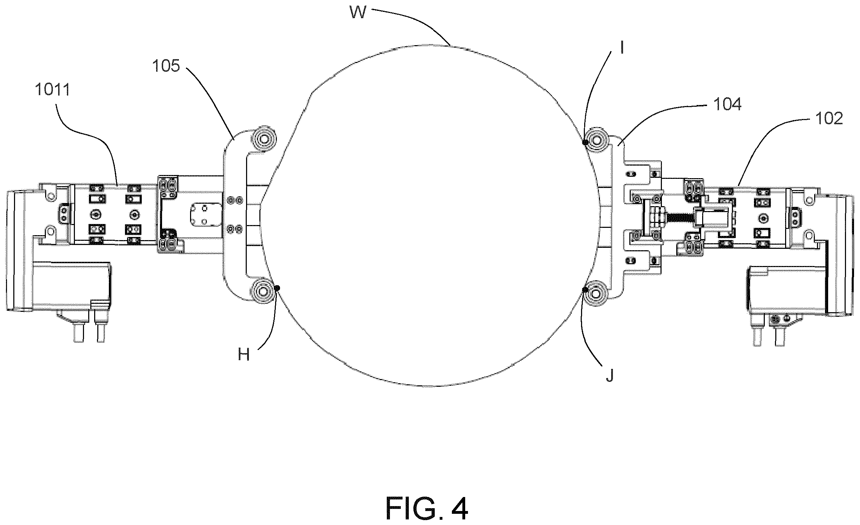

The substrate W may be a circular substrate with a notch. As shown in Figure 3, when the first positioning claw 104 and the second positioning claw 105 are in contact with the edge of the substrate W at the same time, if the notch is just in the vicinity of the second positioning claw 105, only a point H of the second positioning claw 105 is in contact with the edge of the substrate W, because there are two points I and J of the edge of the substrate W in contact with the first positioning claw 104, so the existence of the notch will not affect the calculation of the center point position of the substrate W. The substrate W may also be a circular substrate with a flat edge, as shown in Fig. 4, the existence of the flat edge will not affect the calculation of the center point position of the substrate W.

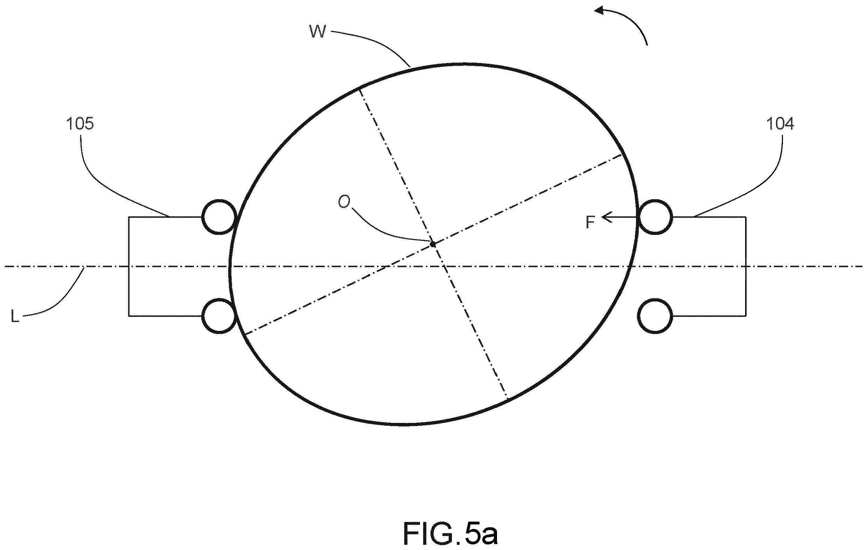

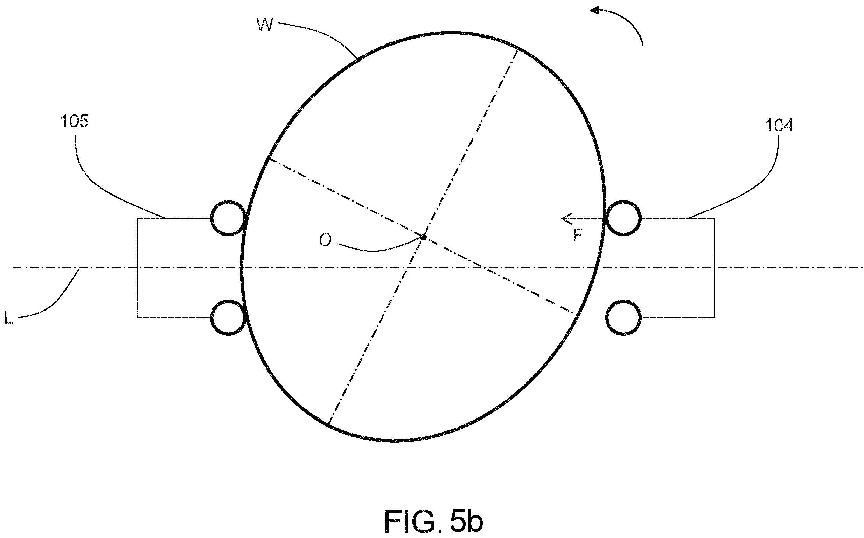

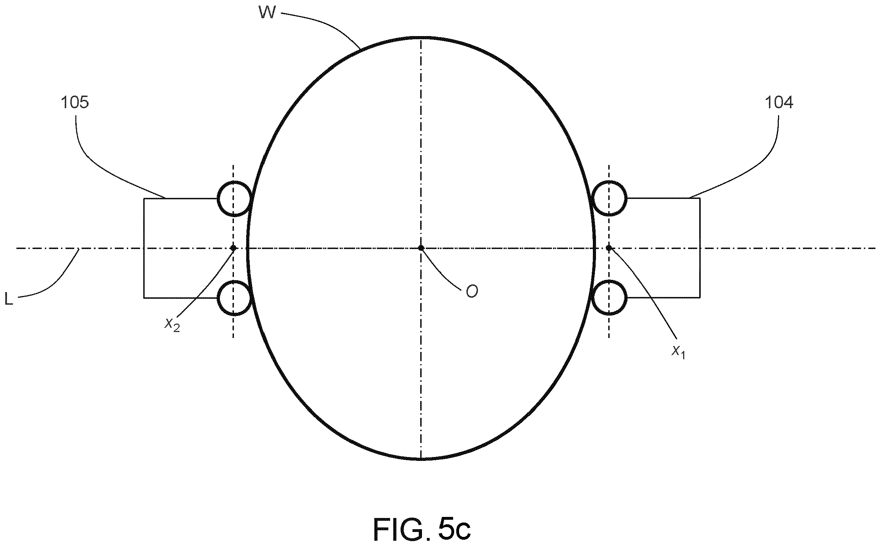

The substrate W may also be an oval substrate. When two points on the edge of the substrate W are in contact with the second positioning claw 105 but the center point O of the substrate W is not on the straight line L, such as the position shown in Fig. 5a, the thrust F exerted by the first positioning claw 104 on the substrate W will cause the substrate W to rotate counterclockwise, and the substrate W passes through the position shown in Fig. 5b and ultimately reaches the position shown in Fig. 5c, at this time, two points of the edge of the substrate W are in contact with the first positioning claw 104, the center point O and the minor axis of the substrate W are located on the straight line L, and the center point O of the substrate W is the midpoint of $x_1$ and $x_2$, $x_1$ is the center point of the first positioning claw 104, $x_2$ is the center point of the second positioning claw 105. The arc arrows in Fig. 5a and Fig. 5b indicate the rotation direction of the substrate W when the first positioning claw 104 pushes the substrate W.

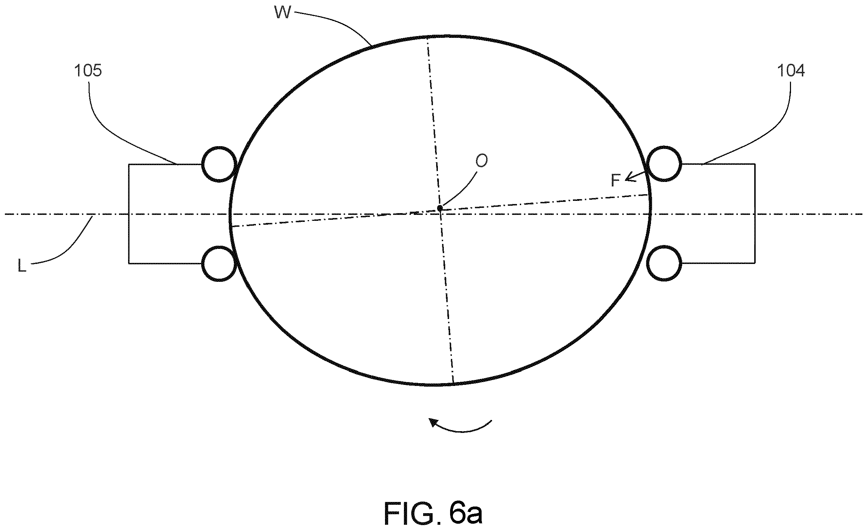

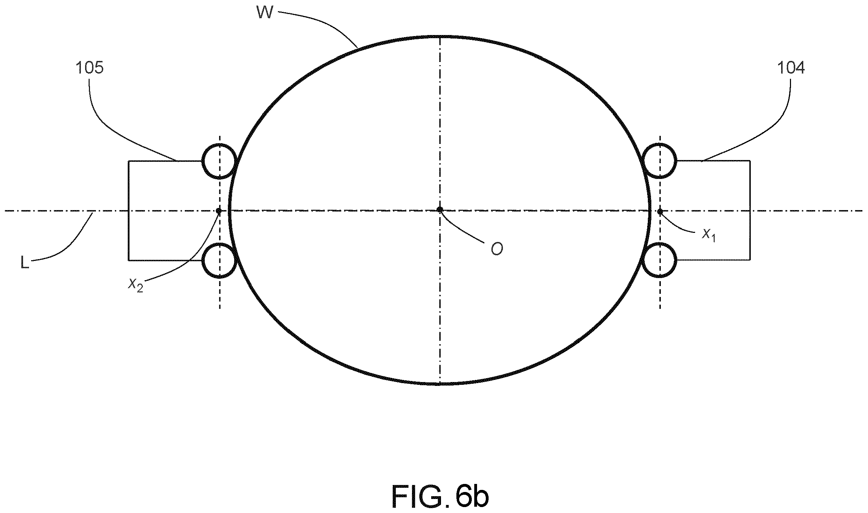

When the substrate W is at the position shown in Fig. 6a, the thrust F exerted by the first positioning claw 104 on the substrate W will cause the substrate W to rotate clockwise, so that the substrate W will finally be at the position shown in Fig. 6b. The center point O and the major axis of the substrate are located on the straight line L, and the center point O of the substrate W is the midpoint of $x_1$ and $x_2$, $x_1$ is the center point of the first positioning claw 104, $x_2$ is the center point of the second positioning claw 105. The arc-shaped arrow in Fig. 6a indicates the rotation direction of the substrate W when the first positioning claw 104 pushes the substrate W.

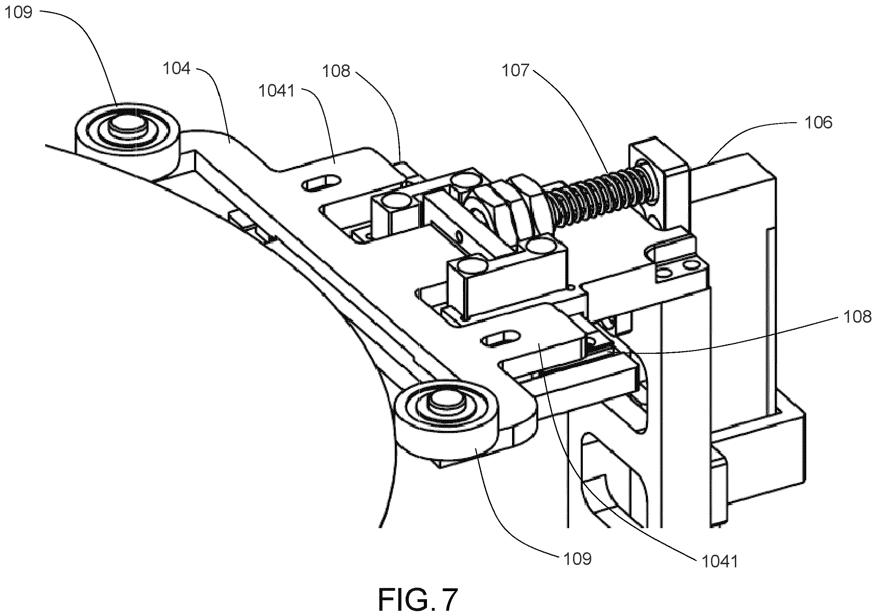

As shown in Fig. 7, a pressure sensor 106 is set on the moving arm 103, and the pressure sensor 106 is connected to the first positioning claw 104 for measuring the pressure between the edge of the substrate W and the first positioning claw 104. During each measurement, after the first positioning claw 104 and the second positioning claw 105 are in contact with the edge of the substrate W at the same time, the pressure between the first positioning claw 104 and the substrate W is kept at a constant value, such as 5N or within a set range, for example, between 4.8N-5.2N, which can reduce the error caused by the poor contact between the first positioning claw 104 and the substrate W, and make the calculation of the center point position of the substrate W more accurate.

Using the device of this embodiment to measure the deviation between the center of the substrate and the standard center comprises the following steps:

S 1, using a supporting mechanism (not shown in the figure) to horizontally lift the substrate W and abut against the second positioning claw 105. The above-mentioned supporting mechanism can be a smooth horizontal platform or an air-floating platform.

S2, the position of the reference arm 101 is fixed, the moving arm 103 starts from the initial coordinate, and is driven by the first linear module 102 to translate along the straight line L, and the first positioning claw 104 pushes the substrate W until the first positioning claw 104 and the second positioning claw 105 are in contact with the edge of the substrate W at the same time.

S3, the moving arm 103 slowly translates along the straight line L, during which the pressure sensor 106 measures the pressure in real time.

S4, when the pressure reaches the set value or within the set range, the moving arm 103 stops moving and keeps the pressure at the set value or within the set range.

S5, calculate the center point position of the substrate W according to the coordinates of the reference arm 101 and the moving arm 103, so as to obtain the deviation between the center of the substrate W and the standard center.

In the step S2, the initial coordinate of the reference arm 101 and the initial coordinate of the moving arm 103 can be obtained in advance. In the step S5, the coordinate of the reference arm 101 is the initial coordinate of the reference arm 101. Since the displacement amount of the moving arm 103 on the first linear module 102 can be read, the coordinate of the moving arm 103 can be calculated according to the initial coordinate of the moving arm 103 and the displacement amount of the moving arm 103 on the first linear module 102.

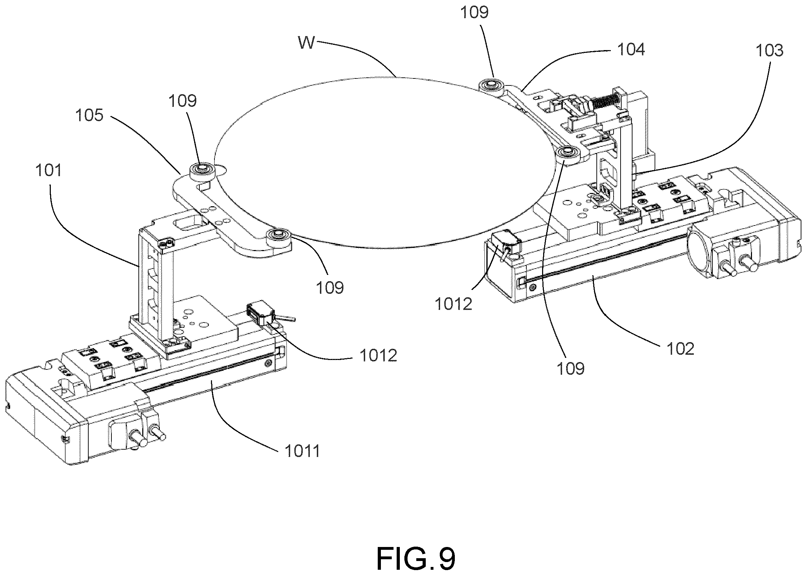

A displacement sensor 1012 can also be used to obtain the motion amount of the first linear module 102. As shown in Figure 9, the displacement sensor 1012 can be fixed on the first linear module 102 and disposed opposite to the moving arm 103. After the moving arm 103 moves, the displacement sensor 1012 can measure the moving distance of the moving arm 103, and the moving distance is the displacement amount of the moving arm 103 on the first linear module 102.

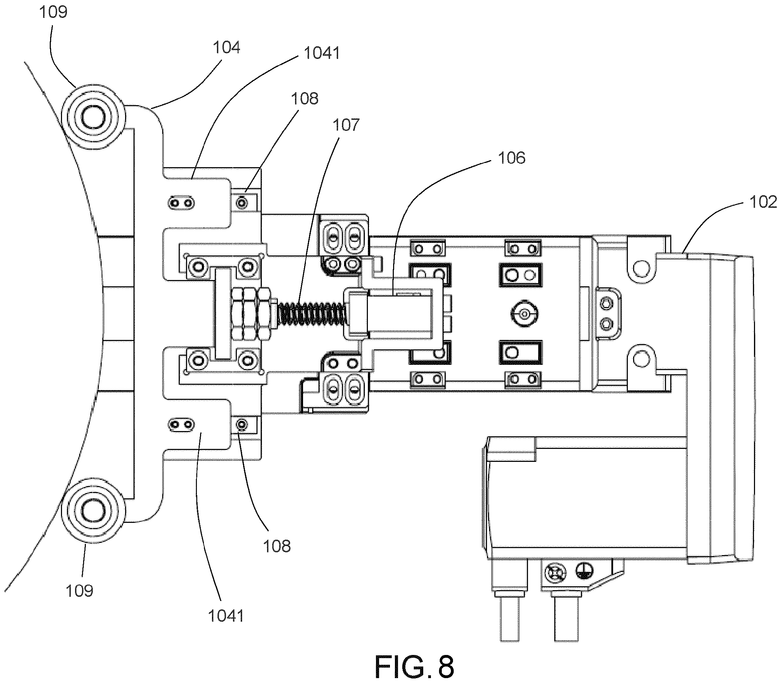

As shown in Fig. 7 to Fig. 9, the first positioning claw 104 is connected to the pressure sensor 106 through a spring 107, and the spring 107 plays a cushioning role to prevent the first positioning claw 104 from damaging the substrate W, and the measurement value of the pressure sensor 106 is more accurate.

One strip protrusion 1041 is disposed on each side of the first positioning claw 104, and two parallel tracks 108 are disposed on the moving arm 103, the two strip protrusions 1041 are connected to the two tracks 108 in a one-to-one correspondence, and the first positioning claw 104 may slide along the track 108.

The first positioning claw 104 and the second positioning claw 105 are respectively provided with two rollers 109, and the rolling surfaces of the rollers 109 are used to abut against the edge of the substrate W. When the first positioning claw 104 pushes the substrate W to rotate, rolling friction occurs between the roller 109 and the edge of the substrate W, the edge of the substrate W is not easily damaged.

The rollers 109 may also be replaced by a circular ball embedded in the heads of the first positioning claw 104 and the second positioning claw 105.

The deviation measurement device of the embodiment further includes a second linear module 1011, and the second linear module 1011 is connected with the reference arm 101. The reference arm 101 and the moving arm 103 may be translated along the straight line L respectively driven by the second linear module 1011 and the first linear module 102. After measuring the deviation between the center of the substrate W and the standard center, in order to move the center of the substrate W to the standard center, the reference arm 101 and the moving arm 103 can move synchronously with the substrate W to align the center of the substrate W with the standard center.

The displacement amount of the reference arm 101 on the second linear module 1011 can be directly read, or a displacement sensor 1012 can be used to obtain the displacement amount of the reference arm 101 on the second linear module 1011. As shown in Fig 9, the displacement sensor 1012 may be fixed on the second linear module 1011, and is disposed opposite to the reference arm 101. When the reference arm 101 moves, the displacement sensor 1012 can measure the moving distance of the reference arm 101. The moving distance is a displacement amount of the reference arm 101 on the second linear module 1011.

Second Embodiment

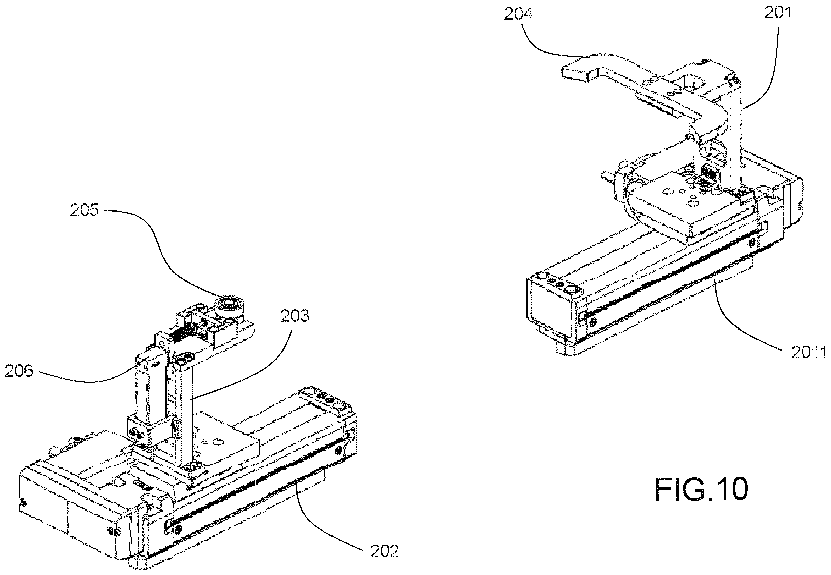

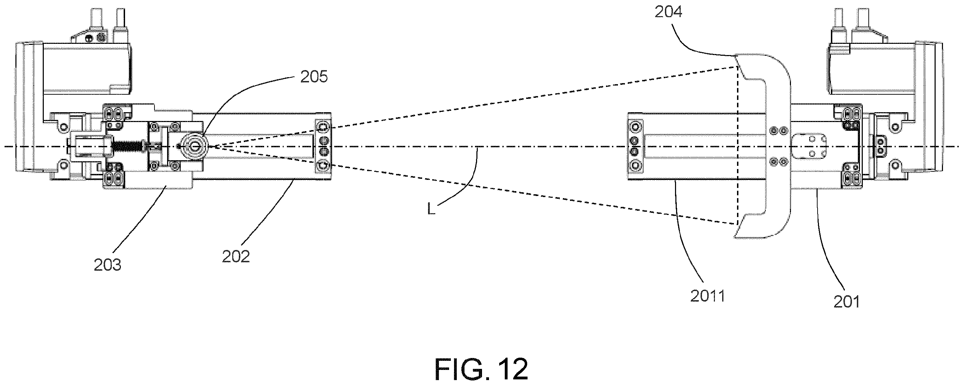

As shown in Fig. 10 and Fig. 12, the embodiment of the present invention discloses a deviation measurement device, which measures the deviation between the center of the substrate and the standard center. The deviation measurement device includes a reference arm 201, a first linear module 202 and a moving arm 203. A positioning claw 204 is disposed on the reference arm 201, and the positioning claw 204 is configured to abut against two points on the edge of the substrate. A contact head 205 and a pressure sensor 206 are disposed on the moving arm 203. The contact head 205 is configured to abut against one point on the edge of the substrate, and the pressure sensor 206 is connected to the contact head 205 to measure a pressure between the edge of the substrate and the contact head 205. The moving arm 203 is disposed opposite to the reference arm 201, and a connecting line between the center of the positioning claw 204 and the center of the contact head 205 is a straight line L, the straight line L passes through the standard center. The first linear module 202 is connected to the moving arm 203, and the moving arm 203 may be driven by the first linear module 202 to translate along the straight line L. The moving arm 203 pushes the substrate to make the edge of the substrate be in contact with the positioning claw 204 and the contact head 205, at this time, the center of the substrate is located on the straight line L, and a deviation between the center of the substrate and the standard center may be calculated according to coordinates of the reference arm 201 and the moving arm 203.

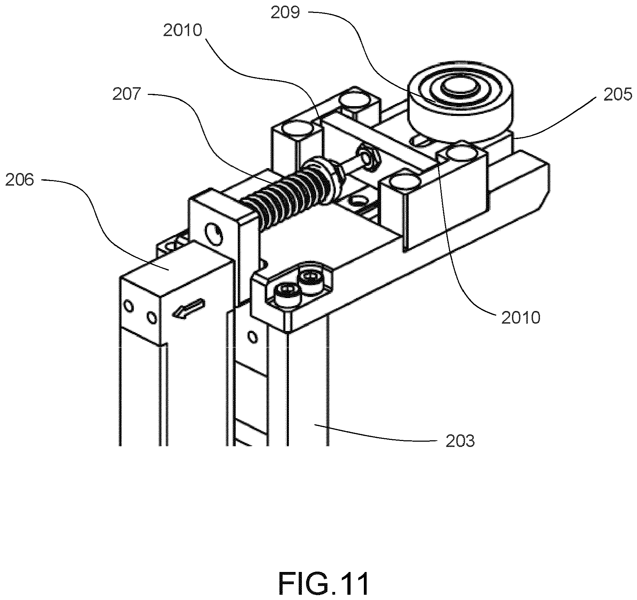

As shown in Fig. 11, the contact head 205 is connected to the pressure sensor 206 through a spring 207. A sliding groove 2010 is disposed on the moving arm 203, and the contact head 205 may slide along the sliding groove 2010. In order to prevent the contact head 205 from scratching the edge of the substrate, a roller 209 is disposed on the contact head 205, the roller surface of the roller 209 is used to abut against the edge of the substrate. If the substrate and the contact head 205 are relatively slid in a process of contacting, the friction between the substrate and the contact head 205 is a rolling friction instead of a sliding friction, and the rolling friction causes less damage to the edge of the substrate. In addition, the roller 209 may be replaced by a circular ball embedded in the head of the contact head 205.

Measuring the deviation between the center of the substrate and the standard center using the device of the embodiment comprises the following steps:

S 1, using a supporting mechanism (not shown in the figure) to horizontally lift the substrate W and abut against the positioning claw 204. The above-mentioned supporting mechanism can be a smooth horizontal platform or an air-floating platform.

S2, the reference arm 201 is fixed, the moving arm 203 starts from the initial coordinate and is driven by the first linear module 202 to translate along the straight line L, and the contact head 205 pushes the substrate W until the positioning claw 204 and the contact head 205 are in contact with the edge of the substrate W at the same time.

S3, the moving arm 203 slowly translates along the straight line L, and in this process, the pressure sensor 206 measures the pressure in real time.

S4, after the pressure reaches a set value or a set range, the moving arm 203 stops moving and keeps the pressure within the set value or the set range, and at this time, the moving arm 203 is located at an end coordinate.

S5, calculate the diameter d1 of the substrate W, so as to obtain the deviation n between the center of the substrate W and the standard center. The calculation formula is as follows:

$$d1 = \frac{d0 + 2\sin\theta * \left[\left(\frac{d0}{2}\right) - m\right]}{1 + \sin\theta}$$

$$n = \frac{d0 - d1}{2\sin\theta}$$

where d0 is a standard diameter, the positioning claw 204 is V-shaped, $\theta$ is half of the opening angle of the positioning claw 204, m=$\Delta$1-$\Delta$0, and $\Delta$1 is a translation distance between the initial coordinate and the end coordinate of the moving arm 203, $\Delta$0 is a standard translation distance of the moving arm 203, and the standard translation distance is obtained in advance, and the method for obtaining the standard translation distance is as follows: using a substrate with a standard diameter d0 as a substrate in the foregoing measurement steps, and performing the step S1 to step S4, and the obtained translation distance between the initial coordinate and the end coordinate of the moving arm 203 is the standard translation distance.

In the step S2, the positioning claw 204 and the contact head 205 are in contact with three points on the edge of the substrate, and because the connecting lines among the three points form an isosceles triangle, the center of the circular substrate must be located on the straight line L.

The following describes the calculation principle of the diameter d1 of the substrate and the deviation n between the center of the substrate and the standard center by taking the standard diameter of 300 mm as an example.

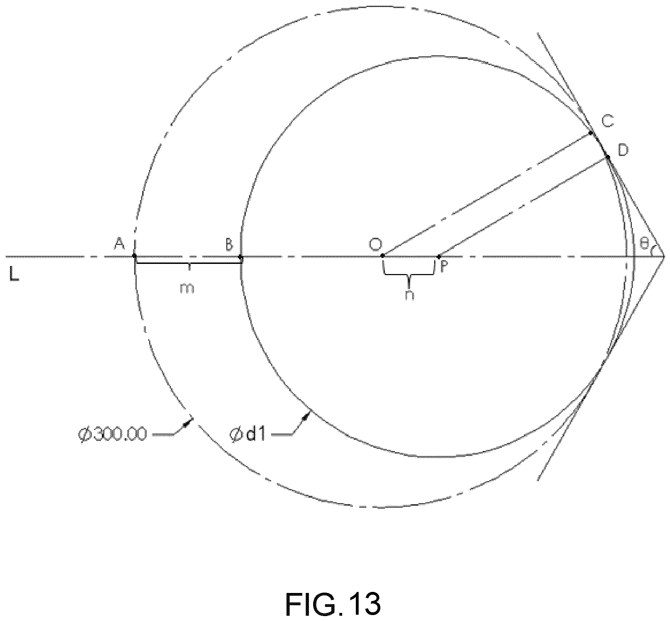

As shown in Fig. 13, the dotted circle represents a standard substrate with a diameter d0 of 300 mm, the solid circle represents a substrate with an unknown diameter (diameter d1), and the right fold line represents the V-shaped positioning claw 204. O is the standard center, i.e. the center of the standard substrate, and P is the center of the substrate of unknown diameter. Point A is a contact point between the contact head 205 and the standard substrate, point B is a contact point between the contact head 205 and the substrate of unknown diameter, point C is a contact point between the standard substrate and the positioning claw 204, and point D is a contact point between the substrate of unknown diameter and the positioning claw 204. The length of AB is defined as m, where m is a directional quantity. When d1<300, m>0, and when d1>300, m<0. The length of OP is defined as n, and n is also a directional quantity. When P is on the right side of O, n>0, and when P is on the left side of O, n<0. The angle $\theta$ is 1 / 2 of the opening angle of the positioning claw 204.

The relationship between the deviation n and the diameter d1 of the substrate with unknown diameter can be obtained from Fig. 13:

$$n = \frac{300 - d1}{2\sin\theta} \qquad (1)$$

From Fig. 13, it can be obtained that m conforms to the following equation:

$$m = 150 - \left(\frac{d1}{2} - n\right) \qquad (2)$$

It can be obtained by combining the above two formulas:

$$d1 = \frac{300 + 2\sin\theta * (150 - m)}{1 + \sin\theta} \qquad (3)$$

Therefore, the diameter d1 of the substrate may be first measured according to Formula (3), and after the diameter d1 is measured, the deviation n between the center of the substrate with unknown diameter and the standard center may be calculated according to Formula (1).

The device of the embodiment further includes a second linear module 2011. The second linear module 2011 is connected to the reference arm 201. The reference arm 201 and the moving arm 203 may be translated along the straight line L respectively driven by the second linear module 2011 and the first linear module 202. After measuring the deviation between the center of the substrate W and the standard center, in order to move the center of the substrate W to the standard center, the reference arm 201 and the moving arm 203 may move synchronously with the substrate W to make the center of the substrate W be aligned with the standard center.

The motion amounts of the first linear module 202 and the second linear module 2011 can be read directly or measured by displacement sensors mounted on the first linear module 202 and the second linear module 2011. Specifically, the displacement sensor on the first linear module 202 is disposed opposite to the moving arm 203, and is configured to measure a moving distance of the moving arm 203, and the displacement sensor on the second linear module 2011 is disposed opposite to the reference arm 201, and is configured to measure a moving distance of the reference arm 201.

In summary, the present invention, by means of the above-described embodiments and related illustrations, has specifically and in detail disclosed the relevant technology, so that those skilled in the art can be implemented accordingly. The above-mentioned embodiments are only used to illustrate the present invention, and are not used to limit the present invention, the scope of rights of the present invention shall be defined by the Claims of the invention. Changes in the number of components or substitution of equivalent components as described herein shall still be within the scope of the present invention.

**Claims**

1. A deviation measurement device that measures the deviation between the center of a substrate and a standard center, comprising a reference arm, a moving arm and a first linear module, wherein the moving arm is provided with a first positioning claw, and the first positioning claw is used to abut against two points on the edge of the substrate, and the reference arm is provided with a second positioning claw, the second positioning claw is used to abut against two points on the edge of the substrate, the moving arm is set opposite to the reference arm, a connecting line between the center of the first positioning claw and the center of the second positioning claw is a straight line L, and the straight line L passes through the standard center, and the first linear module is connected to the moving arm, and the moving arm is driven by the first linear module to translate along the straight line L, the first positioning claw pushes the substrate until the first positioning claw and the second positioning claw contact the edge of the substrate at the same time, at this time, the center of the substrate is located on the straight line L, and the deviation between the substrate center and the standard center is calculated according to coordinates of the reference arm and the moving arm, and the substrate is a circular substrate or an oval substrate.

2. The deviation measurement device according to claim 1, wherein the substrate has a notch or a flat edge.

3. The deviation measurement device according to claim 1, further comprising a pressure sensor being disposed on the moving arm, the pressure sensor being connected to the first positioning claw for measuring the pressure between the edge of the substrate and the first positioning claw.

4. The deviation measurement device according to claim 3, wherein the first positioning claw is connected to the pressure sensor through a spring.

5. The deviation measurement device according to claim 4, wherein one strip protrusion is disposed on each side of the first positioning claw, and two parallel tracks are disposed on the moving arm, the two strip protrusions are connected to the two tracks in a one-to-one correspondence, and the first positioning claw slides along the tracks.

6. The deviation measurement device according to claim 1, wherein the first positioning claw and the second positioning claw are respectively provided with two rolling elements, and the rolling surfaces of the rolling elements are used to abut against the edge of the substrate.

7. The deviation measurement device according to claim 6, wherein the rolling elements are rollers.

8. The deviation measurement device according to claim 1, further comprising a second linear module, the second linear module being connected with the reference arm, the reference arm being driven by the second linear module to translate along the straight line L, the reference arm and the moving arm moving synchronously with the substrate to align the center of the substrate with the standard center.

9. The deviation measurement device according to claim 8, wherein both the displacement amount of the moving arm on the first linear module and the displacement amount of the reference arm on the second linear module are directly read.

10. The deviation measurement device according to claim 8, wherein the first linear module is fixed with a displacement sensor, and the displacement sensor is arranged opposite to the moving arm for measuring the moving distance of the moving arm, and the second linear module is fixed with a displacement sensor, and the displacement sensor is arranged opposite to the reference arm for measuring the moving distance of the reference arm.

11. A deviation measurement device that measures the deviation between the center of a substrate and a standard center, comprising a reference arm, a moving arm and a first linear module, wherein the reference arm is provided with a positioning claw, the positioning claw is used to abut against two points on the edge of the substrate, and the moving arm is provided with a contact head and a pressure sensor, the contact head is used to abut against a point on the edge of the substrate, the pressure sensor is connected to the contact head, the pressure sensor measures the pressure between the edge of the substrate and the contact head, the moving arm is set opposite to the reference arm, the connecting line between the center of the positioning claw and the center of the contact head is a straight line L, and the straight line L passes through the standard center, the first linear module is connected to the moving arm, and the moving arm is driven by the first linear module to translate along the straight line L, and when measuring, the moving arm starts from an initial coordinate and pushes the substrate until the positioning claw and the contact head are in contact with the edge of the substrate at the same time, at this time, the center of the substrate is on the straight line L, and the moving arm is located at an end coordinate, and then calculate the diameter d1 of the substrate, so as to obtain the deviation n between the substrate center and the standard center, the calculation formula is as follows:

$$d1 = \frac{d0 + 2\sin\theta * \left[\left(\frac{d0}{2}\right) - m\right]}{1 + \sin\theta}$$

$$n = \frac{d0 - d1}{2\sin\theta}$$

among them, d0 is the standard diameter, the positioning claw is V-shaped, $\theta$ is half of the opening angle of the positioning claw, m=$\Delta$1-$\Delta$0, $\Delta$1 is the translation distance between the initial coordinate and the end coordinate of the moving arm, and $\Delta$0 is a standard translation distance of the moving arm, the standard translation distance is obtained in advance, a method for obtaining the standard translation distance is: the substrate with the standard diameter d0 is used as the substrate for measurement, and the obtained translation distance between the initial coordinate and the end coordinate of the moving arm is the standard translation distance.

12. The deviation measurement device according to claim 11, wherein the contact head is connected with the pressure sensor through a spring.

13. The deviation measurement device according to claim 11, wherein a sliding groove is disposed on the moving arm, and the contact head slides along the sliding groove.

14. The deviation measurement device according to claim 11, wherein the contact head is provided with a rolling element, and the rolling surface of the rolling element is used to abut against the edge of the substrate.

15. The deviation measurement device according to claim 14, wherein the rolling element is a roller.

16. The deviation measurement device according to claim 11, further comprising a second linear module, the second linear module being connected with the reference arm, and the reference arm being driven by the second linear module to translate along the straight line L, the reference arm and the moving arm moving synchronously with the substrate to align the center of the substrate with the standard center.

17. The deviation measurement device according to claim 16, wherein both the displacement amount of the moving arm on the first linear module and the displacement amount of the reference arm on the second linear module are directly read.

18. The deviation measurement device according to claim 16, wherein the first linear module is fixed with a displacement sensor, and the displacement sensor is arranged opposite to the moving arm for measuring the moving distance of the moving arm, and the second linear module is fixed with a displacement sensor, and the displacement sensor is arranged opposite to the reference arm for measuring the moving distance of the reference arm.

FIG.1

FIG. 2

FIG.3

FIG. 4

FIG.5a

FIG. 5b

EP 4 357 730 A1

EP 4 357 730 A1

FIG. 5c

FIG. 6a

FIG. 6b

FIG.7

EP 4 357 730 A1

FIG. 8

FIG.9

EP 4 357 730 A1

FIG.10

209

2010

207

206

205

2010

203

FIG.11

EP 4 357 730 A1

FIG. 12

FIG.13

## INTERNATIONAL SEARCH REPORT

| | International application No. |
|---|---|
| | **PCT/CN2022/094167** |

**A. CLASSIFICATION OF SUBJECT MATTER**

G01B 21/04(2006.01)i

According to International Patent Classification (IPC) or to both national classification and IPC

**B. FIELDS SEARCHED**

Minimum documentation searched (classification system followed by classification symbols)

G01B

Documentation searched other than minimum documentation to the extent that such documents are included in the fields searched

Electronic data base consulted during the international search (name of data base and, where practicable, search terms used)

CNABS, EPODOC, DWPI, CNTXT, CNKI: 中点, 中心, 圆, 基准, 夹具, 偏差, 坐标, center, clamp?, hold???, circle, coordinat+, different+

**C. DOCUMENTS CONSIDERED TO BE RELEVANT**

| Category* | Citation of document, with indication, where appropriate, of the relevant passages | Relevant to claim No. |
|---|---|---|
| X | CN 210180369 U (YANCHENG JIAAODA MACHINERY CO., LTD.) 24 March 2020 (2020-03-24) <br> description, paragraphs 0015-0019, and figures 1-2 | 1-10 |
| A | CN 108151614 A (SHENYANG AIRCRAFT INDUSTRY GROUP CO., LTD.) 12 June 2018 (2018-06-12) <br> entire document | 1-18 |
| A | CN 212705770 U (ZHEJIANG GUANGHE INTELLIGENT TECHNOLOGY CO., LTD.) 16 March 2021 (2021-03-16) <br> entire document | 1-18 |
| A | CN 205975362 U (NO. 6 ENGINEERING CO., LTD. OF FHEC OF CCCC) 22 February 2017 (2017-02-22) <br> entire document | 1-18 |
| A | CN 210689429 U (HENGDIAN GROUP DMEGC MAGNETICS CO., LTD.) 05 June 2020 (2020-06-05) <br> entire document | 1-18 |
| A | CN 101196394 A (SHANGHAI UNIVERSITY) 11 June 2008 (2008-06-11) <br> entire document | 1-18 |

☑ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 August 2022** | **24 August 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT

| International application No. |
| --- |
| **PCT/CN2022/094167** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 11118458 A (FUJITSU LTD.) 30 April 1999 (1999-04-30)<br>      entire document | 1-18 |

Form PCT/ISA/210 (second sheet) (January 2015)

**INTERNATIONAL SEARCH REPORT**
Information on patent family members

International application No.

**PCT/CN2022/094167**

| Patent document cited in search report | | | Publication date (day/month/year) | Patent family member(s) | | | Publication date (day/month/year) |
|---|---|---|---|---|---|---|---|
| CN | 210180369 | U | 24 March 2020 | None | | | |
| CN | 108151614 | A | 12 June 2018 | CN | 208269792 | U | 21 December 2018 |
| CN | 212705770 | U | 16 March 2021 | None | | | |
| CN | 205975362 | U | 22 February 2017 | None | | | |
| CN | 210689429 | U | 05 June 2020 | None | | | |
| CN | 101196394 | A | 11 June 2008 | None | | | |
| JP | 11118458 | A | 30 April 1999 | JP | 3333724 | B2 | 15 October 2002 |

Form PCT/ISA/210 (patent family annex) (January 2015)